# EUROPEAN PATENT APPLICATION

(11) **EP 4 715 952 A1**
(43) Date of publication of application: **25.03.2026**
(21) Application number: 25202116.7
(22) Date of filing: 15.09.2025
(51) Int. Cl.: H01M 10/42, G01R 31/36, H01M 50/519, H01M 50/569, H05K 3/328

(54) **INFORMATION ACQUISITION ASSEMBLIES, BATTERY PACKS AND ELECTRICAL DEVICES**

(30) Priority: 24.09.2024 CN 202422341299 U; 03.12.2024 WO PCT/CN2024/136368
(71) Applicant: Eve Energy Co., Ltd., Huizhou, Guangdong 516006 (CN)
(72) Inventor: MA, Jinsi, Huizhou, 516006 (CN)
(74) Representative: Studio Torta S.p.A.

(57) **Abstract**

An information acquisition assembly (4) includes a circuit board and a conductive bar. The circuit board includes a circuit board body (1) and a plurality of circuit board branches (2). The conductive bar includes a plurality of conductive components (3). At least one of the circuit board branches (2) is electrically connected between the circuit board body (1) and one of the conductive components(3), and is separate from the circuit board body (1) and the one of the conductive components (3).

## Description

### TECHNICAL FIELD

The present application relates to power battery technologies, and in particular to information acquisition assemblies, battery packs and electrical devices.

### BACKGROUND

Generally, in an information acquisition assembly of a battery pack, a circuit board body is connected with a circuit branch through a nickel sheet or the bending of the circuit board branch. However, such connection is costly. Additionally, the circuit board body and the circuit board branch are usually designed as integral, so that the connection between the circuit board body and the circuit board branch cannot be adjusted as defined.

### SUMMARY

According to some embodiments of the present application, an information acquisition assembly includes: a circuit board including a circuit board body and a plurality of circuit board branches; and a conductive bar including a plurality of conductive components each configured to be electrically connected to a cell. At least one of the circuit board branches is electrically connected between the circuit board body and one of the conductive components, and is separate from the circuit board body and the one of the conductive components.

According to some embodiments of the present application, a battery pack includes the above information acquisition assembly.

According to some embodiments of the present application, an electrical device includes the above information acquisition assembly.

### BRIEF DESCRIPTION OF THE DRAWINGS

FIG. 1 is a schematic diagram of an information acquisition assembly and a battery management assembly according to one or more embodiments of the present application.
FIG. 2 is a schematic diagram of a circuit board branch in an information acquisition assembly according to one or more embodiments of the present application.
FIG. 3 is a schematic diagram of truncation holes formed during the manufacturing of an information acquisition assembly according to one or more embodiments of the present application.

### DETAILED DESCRIPTION

Some embodiments of the present application will be described in detail below with reference to the accompanying drawings. The embodiments are described for illustrative purposes only and are not intended to limit the present application.

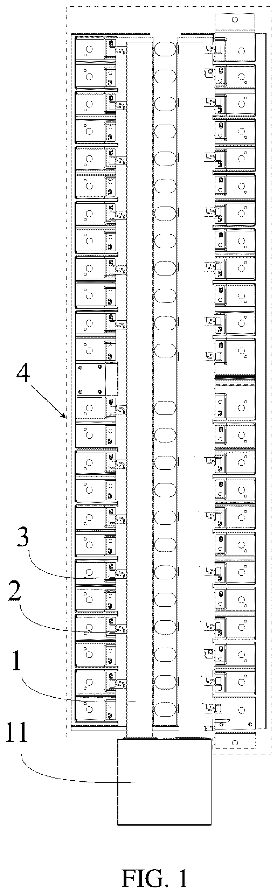

As shown in FIG. 1, an information acquisition assembly 4 according to one or more embodiments of the present application includes a circuit board and a conductive bar. The circuit board includes a circuit board body 1 and a plurality of circuit board branches 2. The conductive bar includes a plurality of conductive components 3 each of which can be electrically connected to a cell. At least one circuit board branch 2 is electrically connected between the circuit board body 1 and a corresponding conductive component 3, and is separate from the circuit board body 1 and the corresponding conductive component 3.

In this embodiment, the circuit board branch 2 is separate from the circuit board body 1 and the corresponding conductive component 3, so that the design of a definable connection between the circuit board branch 2 and the circuit board body 1 can be implemented by welding.

Herein, a definable connection means: when the welding between the circuit board body 1 and the circuit board branches 2 is completed by the welding process, any signal connection line 13 that is electrically connected to the battery management assembly 11 can be selectively electrically connected to any one of the circuit board branches 2. For example, the circuit board body 1 includes a plurality of signal connection lines 13 represented by N1, N2, ..., Nn, and the circuit board branches 2 are represented by M1, M2, ..., Mm, where m = n. When the welding between the circuit board body 1 and the circuit board branches 2 is completed by welding process, any one of M1, M2, ..., Mm can be selectively electrically connected to any one of N1, N2, ..., Nn.

The circuit board body 1 may be a flexible printed circuit (FPC) body, the circuit board branch 2 may be a flexible flat cable (FFC) branch, and the conductive component 3 may be a busbar. The circuit board body 1 may include a plurality of signal connection lines 13, which are independent of each other and arranged side by side. Any signal connection line 13 may be connected between the signal acquisition port of the battery management assembly 11 and a corresponding conductive component 3.

In an embodiment, referring to FIG. 1, an end of the circuit board branch 2 is welded to the circuit board body 1, and the other end of the circuit board branch 2 is welded to a corresponding conductive component 3.

It can be understood that the electrical connection between the circuit board body 1 and the circuit board branch 2 is achieved by welding. At the welding position, the insulating layer between the circuit board branch 2 and the circuit board body 1 needs to be hollowed out so that the conductive part of the circuit board body 1 is in direct contact with the conductive part of the circuit board branch 2.

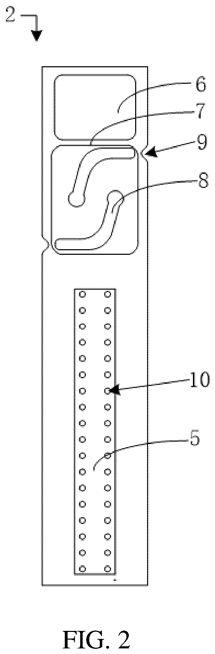

In an embodiment, referring to FIG. 2, the circuit board branch 2 includes a body pad 5, and an end of the circuit board branch 2 is provided with a body pad opening to expose the body pad 5, so that the body pad 5 can be welded to the circuit board body 1.

The body pad 5 is configured to weld with the circuit board body 1, and the body pad opening is configured to hollow out the insulating layer on a side of the body pad 5 facing the circuit board body 1 to expose the body pad 5.

It is understandable that in an area corresponding to the body pad opening, part of the insulating layer of the circuit board body 1 needs to be removed to expose the conductive part of the circuit board body 1, so that the conductive part is aligned with the body pad 5 and welded.

In an embodiment, referring to FIG. 2, the body pad 5 is provided with at least one through hole 10. The through hole 10 is provided through the body pad 5 along a thickness direction of the body pad 5.

In another embodiment, the body pad 5 is provided with a plurality of through holes 10 which are evenly arranged on the body pad 5. The through holes 10 are circular holes, and the diameters of the circular holes may be the same.

Among them, the through holes 10 are arranged in two rows along a length direction of the circuit board branch 2, a number of through holes 10 in one row is equal to a number of through holes in the other row, and the through holes in two rows are symmetrically arranged about a midline along the row direction.

It can be understood that the through hole 10 is configured to exhaust air during welding between the body pad 5 and the circuit board body 1. On the one hand, it can reduce the number of bubbles generated during welding and make the welding more solid. On the other hand, it can avoid pseudo soldering during welding.

In this embodiment, by providing at least one through hole 10 on the body pad 5, it is possible to avoid pseudo soldering between the body pad 5 and the circuit board body 1, thereby improving the firmness of the solder joint.

In an embodiment, referring to FIG. 2, the circuit board branch 2 includes a conductive pad 6, and a conductive pad opening is provided at the other end of the circuit board branch 2 to expose the conductive pad 6, so that the conductive pad 6 can be welded to the corresponding conductive component 3.

The conductive pad 6 can be welded to the conductive component 3, and the conductive pad opening is configured to hollow out the insulating layer on the side of the conductive pad 6 facing the conductive component 3 to expose the conductive pad 6.

In an embodiment, referring to FIG. 2, the circuit board branch 2 includes a buffer arm 7, which is located between an end and the other end of the circuit board branch 2 and is provided with at least one buffer hole 8.

The buffer arm 7 is located between the body pad 5 and the conductive pad 6, and may be made of the same material as the circuit board branch 2. The buffer arm 7 may include two buffer holes 8, and the buffer holes 8 may be centrally symmetrically arranged.

The buffer hole 8 is configured to absorb the displacement and extrusion stress generated when the circuit board branch 2 of the circuit board expands, and the cross-sectional shape of the buffer hole 8 can be serpentine.

Referring to FIG. 2, the buffer hole 8 may be in an "S" shape as shown in the figure. The depth of the buffer hole 8 may range from 0.15 mm to 0.3 mm, and the length and width of the buffer hole 8 are both equal to or greater than 0.8 mm.

It can be understood that the buffer hole 8 is provided through the circuit board branch 2, and the thickness of the circuit board branch 2 along the film thickness direction is the depth of the buffer hole 8, wherein the depth of the buffer hole 8 can be 0.15 mm, 0.2 mm, 0.25 mm, or 0.3 mm.

It can be understood that when the length or width of the buffer hole 8 is less than 0.8 mm, the yield of the process for manufacturing the buffer hole 8 will be significantly reduced. When the length and width of the buffer hole 8 are equal to or greater than 0.8 mm, on the one hand, the size of the buffer hole 8 is larger, which improves the buffering effect of the buffer hole 8. On the other hand, the process difficulty of manufacturing the buffer hole 8 is reduced, and the yield of manufacturing the buffer hole 8 is improved.

It can be understood that by arranging two or more buffer holes 8 in a centrally symmetrical manner, the buffering effect of the buffer hole 8 on the thermal expansion of the circuit board branch 2 can be further enhanced. At the same time, setting the cross-section of the buffer hole 8 to be serpentine, such as an "S" shape, can also enhance the buffering effect of the buffer hole 8 on stress.

In this embodiment, a buffer arm 7 is provided on the circuit board branch 2, and a buffer hole 8 is formed through the buffer arm 7, so that the stress caused by the expansion of the circuit board branch 2 can be absorbed, thereby preventing the circuit board branch 2 from being abnormal due to the stress.

In an embodiment, referring to FIG. 2, two grooves 9 are disposed on opposite sides of the circuit board branch 2, and the depth of the groove 9 is less than or equal to 1 mm. The grooves 9 are located on opposite surfaces of the circuit board branch 2 along a width direction of the circuit board branch 2, where the surfaces are recessed inward to form the grooves 9.

The grooves 9 located on the opposite surfaces of the circuit board branch 2 may be arranged opposite to each other or staggered, and the shapes and sizes of the grooves 9 may be the same.

It is understandable that when the conductive component 3 is offset along the length direction of the information acquisition assembly 4, the conductive component 3 will be displaced relative to the circuit board branch 2, and the groove 9 has the effect of buffering this displacement. Further, it can also prevent the circuit board branch from being warped due to force when the material is received.

In this embodiment, grooves 9 are provided on opposite sides of the circuit board branch 2 to prevent the circuit board branch 2 from warping abnormally.

In an embodiment, referring to FIG. 2, each buffer hole 8 includes a first end and a second end opposite to each other. In the width direction of the circuit board branch 2, the two first ends of the two buffer holes 8 are aligned, and an end of each groove 9 is aligned with the second end of a corresponding buffer hole 8.

In an embodiment, the information acquisition assembly 4 further includes a protective film, and in the film thickness direction, at least the orthographic projection of the body pad 5 falls within the protective film. The material of the protective film may be polyethylene terephthalate.

It can be understood that since the insulating layers on both sides of the body pad 5 need to be removed, by attaching the protective film to the lower surface of the circuit board branch 2, the lower surface of the body pad 5 after welding is covered by the protective film instead of being exposed, and external erosion will be blocked by the protective film without affecting the body pad 5.

It is understandable that at the conductive pad, a protective adhesive is formed by dispensing on the side of the circuit board branch away from the conductive component, and the protective adhesive covers the surface of the conductive pad away from the conductive component, thereby preventing the external erosion on conductive pad.

In this embodiment, the protective film is configured to protect the body pad 5 after welding is completed, so as to prevent the exposed area of the body pad 5 from being corroded by the environment during use, thereby causing the body pad 5 to fail.

In an embodiment, both the circuit board body 1 and the circuit board branch 2 can be designed as a three-layer laminated structure including a conductive layer and two insulating layers disposed on opposite sides of the conductive layer.

At the position where the circuit board body 1 and the circuit board branch 2 are welded, the insulating layers between the circuit board body 1 and the circuit board branch 2 are hollowed out to facilitate welding of the circuit board body 1 and the circuit board branch 2.

At the position where the circuit board branch 2 and the conductive component 3 are welded, the insulating layer between the circuit board branch 2 and the conductive component 3 is hollowed out to facilitate welding of the circuit board branch 2 and the conductive component 3.

In an embodiment, the length of the body pad ranges from 2 mm to 200 mm, the width of the body pad ranges from 5 mm to 15 mm, the length of the conductive pad 6 ranges from 5 mm to 15 mm, and the width of the conductive pad 6 ranges from 5 mm to 15 mm.

The length of the body pad may be any one of 2 mm, 35.3 mm, 50 mm, 100 mm, or 200 mm, and the width of the body pad may be any one of 5 mm, 8 mm, 10 mm, 13 mm, or 15 mm. The length of the conductive pad 6 can be any one of 5 mm, 8 mm, 10 mm, 13 mm, or 15 mm, and the conductive pad 6 may be any one of 5 mm, 8 mm, 10 mm, 13 mm, or 15 mm.

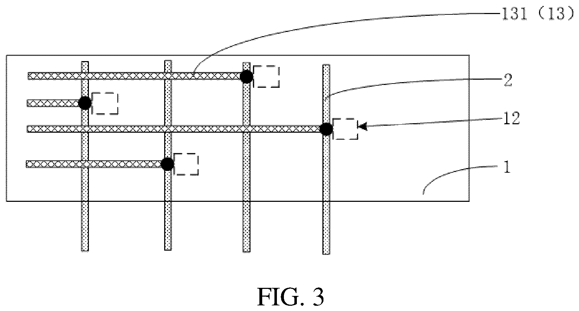

In an embodiment, referring to FIG. 3, it is defined that the circuit board branch 2 and the circuit board body 1 are welded at the first welding point, and the circuit board branch 2 and the conductive component 3 are welded at the second welding point. When manufacturing the information acquisition assembly 4, a truncation hole 12 is formed on the circuit board body 1, and the truncation hole 12 is configured to divide the signal connection line 13 of the circuit board body 1 into a first part 131 and a second part that are independent from each other. The first part 131 is connected between the first welding point and the signal acquisition port of the battery management assembly 11, and the second part is discarded and removed from the information acquisition assembly 4.

It can be understood that by first manufacturing a plurality of signal connection lines 13 of the same length, according to the position of the first welding point where the signal connection line 13 is welded to the circuit board branch 2, and then by setting a truncation hole 12 on the circuit board body 1, the second part of the signal connection line 13 located on the side of the first welding point away from the signal acquisition port is removed.

It is understandable that the second part of the signal connection line 13 does not need to be powered on and is independent from the first part 131, which can avoid electrical safety accidents in the second part of the signal connection line 13 and reduce electrical safety accidents of the information acquisition assembly 4.

It should be noted that the second part of the signal connection line 13 is not included in the structure of the information acquisition assembly 4. Since the truncation hole 12 is located at the edge of the first part 131, the surface of the first part 131 on the side away from the signal acquisition port may appear irregular or rough due to the truncation of the truncation hole 12, where the formation process of the truncation hole 12 can be laser etching.

In this embodiment, the second portion is truncated and removed by forming the truncation hole 12, thereby reducing the occurrence of electrical safety accidents.

The embodiments of the present application also provide a battery pack and an electrical device, both of which include an information acquisition assembly 4 as illustrated in any of the above embodiments, where the information acquisition assembly 4 includes a circuit board and a conductive bar. The circuit board includes a circuit board body 1 and a plurality of circuit board branches 2. The conductive bar includes a plurality of conductive components 3, and each conductive component 3 is configured to be electrically connected to a corresponding cell. At least one circuit board branch 2 is electrically connected between the circuit board body 1 and a corresponding conductive component 3, and the at least one circuit board branch 2 is separate from the circuit board body 1 and the corresponding conductive component 3. By separately arranging the circuit board branch 2 from the circuit board body 1 and the corresponding conductive component 3 and by welding, a definable design of connection between the circuit board branch 2 and the circuit board body 1 is facilitated.

The battery pack further includes a battery management assembly 11, and the battery management assembly 11 includes a plurality of signal acquisition ports orderly connected to a plurality of signal connection lines 13 of the circuit board body 1 in a one-to-one correspondence.

The connection relationship between the signal acquisition ports of the battery management assembly 11 and the signal connection lines 13 of the information acquisition assembly 4 is orderly and corresponding to each other.

In an embodiment, the battery management assembly 11 and the information acquisition assembly 4 are connected via a wiring harness.

Among them, the battery management assembly 11 includes a first male connector, the information acquisition assembly 4 includes a second male connector, and the two ends of the wiring harness respectively include a first female connector and a second female connector. By electrically connecting the first male connector with the first female connector and the second male connector with the second female connector, an electrical connection is achieved between the battery management assembly 11 and the information acquisition assembly 4.

In an embodiment, the battery management assembly 11 and the information acquisition assembly 4 are electrically connected by means of a gold finger plug.

It is understandable that directly electrically connecting the connection end of the battery management assembly 11 and the connection end of the information acquisition assembly 4 by means of a gold finger plug can save the wiring harness for switching and further reduce costs.

The information acquisition assembly 4 of the present application arranges the circuit board body 1, the circuit board branch 2, and the conductive component 3 separately, so that the connection between the circuit board body 1 and the circuit board branch 2 can be definable. By making the connection between the circuit board body 1 and the circuit board branch 2 definable, the related production efficiency can be improved.

The information acquisition assembly 4 of the present application can also realize the electrical connections between the circuit board branch 2 and the circuit board body 1 and between the circuit board branch 2 and the conductive component 3 by welding. Compared with the switching with the nickel sheet in the related art, the present application can save the nickel sheet and reduce the cost.

Some embodiments of the present application have been described in detail above. The description of the above embodiments merely aims to help to understand the present application. Many modifications or equivalent substitutions with respect to the embodiments may occur to those of ordinary skill in the art based on the present application. Thus, these modifications or equivalent substitutions shall fall within the scope of the present application.

## Claims

1. An information acquisition assembly (4), comprising:
a circuit board comprising a circuit board body (1) and a plurality of circuit board branches (2); and
a conductive bar comprising a plurality of conductive components (3) each configured to be electrically connected to a cell,
wherein at least one of the circuit board branches (2) is electrically connected between the circuit board body (1) and one of the conductive components (3), and is separate from the circuit board body (1) and the one of the conductive components (3).

2. The information acquisition assembly (4) according to claim 1, wherein the at least one of the circuit board branches (2) has a first end welded to the circuit board body (1), and a second end welded to the one of the conductive components (3).

3. The information acquisition assembly (4) according to claim 2, wherein the at least one of the circuit board branches (2) comprises a body pad (5), the first end is provided with a body pad opening to expose the body pad (5), and the body pad (5) is welded to the circuit board body (1) through the body pad opening.

4. The information acquisition assembly (4) according to claim 3, wherein the body pad (5) is provided with at least one through hole (10).

5. The information acquisition assembly (4) according to claim 4, wherein the at least one through hole (10) comprises a plurality of through holes (10) evenly arranged in the body pad.

6. The information acquisition assembly (4) according to claim 4 or 5, wherein the at least one through hole (10) comprises a plurality of circular through holes each having a same diameter.

7. The information acquisition assembly (4) according to any one of claims 4-6, wherein the at least one through hole (10) comprises a plurality of through holes (10) arranged in two rows along a length direction of the at least one of the circuit board branches (2), each of the two rows comprises a same number of ones of the through holes (10), and ones of the through holes (10) respectively in the two rows are arranged symmetrical about a center line extending along the length direction.

8. The information acquisition assembly (4) according to any one of claims 3-7, wherein the at least one of the circuit board branches (2) further comprises a conductive pad (6), the second end is provided with a conductive pad opening to expose the conductive pad (6), and the conductive pad (6) is welded to the one of the conductive components (3) through the conductive pad opening.

9. The information acquisition assembly (4) according to any one of claim 3-8, further comprising a protective film,
wherein an orthographic projection of the body pad (5) on the protective film in a thickness direction of the protective film is within the protective film.

10. The information acquisition assembly (4) according to any one of claims 2-9, wherein the at least one of the circuit board branches (2) comprises a buffer arm (7) located between the first end and the second end, and the buffer arm (7) is provided with at least one buffer hole (8).

11. The information acquisition assembly (4) according to claim 10, wherein the at least one buffer hole (8) comprises two buffer holes (8) arranged centrally symmetrical.

12. The information acquisition assembly (4) according to claim 10 or 11, wherein opposite sides of the at least one of the circuit board branches (2) are respectively provided with two grooves (9) arranged opposite to each other or staggered.

13. The information acquisition assembly (4) according to claim 12, wherein the at least one buffer hole (8) comprises a first buffer hole and a second buffer hole, each of the first buffer hole and the second buffer hole having a first end and a second end opposite to each other; and
in a width direction of the at least one of the circuit board branches (2), the first end of the first buffer hole is aligned with the first end of the second buffer hole, and an end of each of the two grooves (9) is aligned with the second end of one of the first buffer hole and the second buffer hole.

14. A battery pack comprising the information acquisition assembly (4) according to any one of claims 1-13.

15. An electrical device comprising the information acquisition assembly (4) according to any one of claims 1-13.
